# EUROPEAN PATENT APPLICATION

(11) **EP 2 768 165 A1**
(43) Date of publication of application: **20.08.2014**
(21) Application number: 14150009.0
(22) Date of filing: 02.01.2014
(51) Int. Cl.: H04B 15/04, G06F 3/01

(54) **Mobile Terminal**

(30) Priority: 19.02.2013 KR 20130017725
(71) Applicant: LG Electronics, Inc., Seoul, 150-721 (KR)
(72) Inventor: Lee, Hyukjae, Seoul (KR); Lee, Byunghwa, Seoul (KR)
(74) Representative: Ter Meer Steinmeister & Partner

(57) **Abstract**

A mobile terminal (200) includes: a terminal body (204) having a battery (240) and an antenna module (205); a printed circuit board (250) having one or more processors disposed between the battery (240) and the antenna module (205), and mounted to the terminal body (204); a partition wall (263) formed at the terminal body (204) such that a region for mounting the antenna module (205) is partitioned from a region for mounting the printed circuit board (250); and a shielding member (270) coupled to the partition wall (263), such that electromagnetic interference of an antenna device due to an operation of the processor is prevented.

## Description

### BACKGROUND OF THE DISCLOSURE

### 1. Field of the Disclosure

The present disclosure relates to a mobile terminal, and particularly, to a mobile terminal capable of shielding electromagnetic interference between devices mounted in the mobile terminal.

### 2. Background of the Disclosure

As a mobile terminal becomes multifunctional, the mobile terminal can be allowed to capture still images or moving images, play music or video files, play games, receive broadcast, etc., so as to be implemented as an integrated multimedia player.

Terminals can be divided into mobile/portable terminals and stationary terminals according to their mobility. The mobile terminal is a portable device that can be carried anywhere and have one or more of a function of performing voice and video calls, a function of inputting/outputting information, a function of storing data, etc.

In order to support and enhance such functions of the terminal, it can be considered to improve the configuration and/or software of the terminal.

As one of such structural improvements, a structure, capable of shielding signal interference between devices which generate electromagnetic signals in the mobile terminal, can be considered.

### SUMMARY OF THE DISCLOSURE

Therefore, an aspect of the detailed description is to provide a mobile terminal having an enhanced structure, and having an electromagnetic wave shielding structure provided with a composite function.

To achieve these and other advantages and in accordance with the purpose of this specification, as embodied and broadly described herein, there is provided a mobile terminal, including: a case having a window on one surface thereof; a battery and an antenna module mounted in the case, and spaced from each other; a printed circuit board having one or more processors, and disposed between the battery and the antenna module; a frame configured to support the printed circuit board; a partition wall formed at the frame such that a region for mounting the antenna module is partitioned from a region for mounting the printed circuit board; and a shielding member coupled to the partition wall, such that electromagnetic interference of an antenna device due to an operation of the processor is prevented.

In an embodiment of the present invention, the mobile terminal may further include a shielding sheet disposed between the printed circuit board and the frame.

In an embodiment of the present invention, the printed circuit board may include: a solder resist layer formed to cover one surface of the printed circuit board; and conductive pattern portions recessed from the solder resist layer, and exposed to outside in a preset pattern.

In an embodiment of the present invention, the shielding member may include: a base portion coupled to the partition wall so as to cover the partition wall; and protrusions bent from the base portion, and formed to be upright with a prescribed inclination angle toward the printed circuit board.

In an embodiment of the present invention, the protrusions may come in electrical-contact with the conductive pattern portions.

In an embodiment of the present invention, the protrusion may be formed of an elastic member such that its inclination angle is variable according to a pressurized degree.

In an embodiment of the present invention, groove portions may be formed on two side surfaces of the partition wall, and part of the base portion may be inserted into the groove portion.

In an embodiment of the present invention, the antenna module may include radiators formed to resonate at a prescribed frequency, respectively. The radiators may be formed as conductive patterns printed onto one surface of a carrier.

In an embodiment of the present invention, the radiators may include one or more points where a maximum current flows when wireless signals are transmitted and received in different modes. The shielding member may be disposed on a virtual line which connects the points and the processor with each other.

In an embodiment of the present invention, the shielding member may be formed in plurality, and each of the plurality of shielding members may be coupled to the partition wall.

To achieve these and other advantages and in accordance with the purpose of this specification, as embodied and broadly described herein, there is also provided a mobile terminal, including: a case having a window on one surface thereof; a battery disposed at an inner central region of the case, and formed to be wirelessly charged; an antenna module mounted in the case, and spaced from the battery; a printed circuit board having one or more processors, and disposed between the battery and the antenna module; a frame configured to support the printed circuit board; a shielding member disposed between the processor and the antenna module; and a partition wall formed at a terminal body such that a region for mounting the antenna module is partitioned from a region for mounting the printed circuit board, wherein the shielding member is detachably coupled to the partition wall.

In an embodiment of the present invention, the printed circuit board may include: a solder resist layer formed to cover one surface of the printed circuit board; and conductive pattern portions recessed from the solder resist layer, and exposed to outside in a preset pattern.

In an embodiment of the present invention, the shielding member may include: a base portion coupled the partition wall in a covering manner; and protrusions bent from the base portion, and formed to be upright with a prescribed inclination angle toward the printed circuit board.

In an embodiment of the present invention, the protrusions may come in electrical-contact with the conductive pattern portions.

In an embodiment of the present invention, the protrusion may be formed of an elastic member such that its upright angle is variable according to a pressurized degree.

In an embodiment of the present invention, groove portions may be formed on two side surfaces of the partition wall, and part of the base portion may be inserted into the groove portion.

In an embodiment of the present invention, the mobile terminal may further include a shielding sheet disposed between the printed circuit board and the frame.

In an embodiment of the present invention, the antenna module may include radiators formed to resonate at a prescribed frequency, respectively. The radiators may be formed as conductive patterns printed onto one surface of a carrier.

In an embodiment of the present invention, the radiators may include one or more points where a maximum current flows when wireless signals are transmitted and received in different modes. The shielding member may be disposed on a virtual line which connects the points and the processor with each other.

Further scope of applicability of the present application will become more apparent from the detailed description given hereinafter. However, it should be understood that the detailed description and specific examples, while indicating preferred embodiments of the disclosure, are given by way of illustration only, since various changes and modifications within the spirit and scope of the disclosure will become apparent to those skilled in the art from the detailed description.

### BRIEF DESCRIPTION OF THE DRAWINGS

The accompanying drawings, which are included to provide a further understanding of the disclosure and are incorporated in and constitute a part of this specification, illustrate exemplary embodiments and together with the description serve to explain the principles of the disclosure.

In the drawings:
FIG. 1 is a block diagram of a mobile terminal according to an embodiment of the present invention;
FIG. 2 is a front perspective view of a mobile terminal according to an embodiment of the present invention;
FIG. 3 is a rear perspective view of the mobile terminal of FIG. 2;
FIG. 4 is an exploded perspective view of FIG. 3;
FIG. 5 is a conceptual diagram of a mobile terminal according to a comparative embodiment, which illustrates a state where a rear case has been removed from a terminal body;
FIG. 6 is a conceptual diagram of a mobile terminal according to an embodiment of the present invention, which illustrates a state where a rear case has been removed from a terminal body;
FIG. 7 is a perspective view illustrating a state where a printed circuit board and an antenna module have been removed from the terminal body of FIG. 6;
FIG. 8 is a perspective view illustrating a state where a printed circuit board and an antenna module have been coupled to the terminal body of FIG. 7;
FIGS. 9A and 9B are conceptual diagrams illustrating a printed circuit board and a shielding member according to an embodiment of the present invention, respectively;
FIG. 10 is a sectional view taken along line 'IV-IV' in FIG. 8; and
FIGS. 11 and 12 are sectional views taken along line 'V-V' in FIG. 8, respectively.

### DETAILED DESCRIPTION OF THE DISCLOSURE

Description will now be given in detail of the exemplary embodiments, with reference to the accompanying drawings. For the sake of brief description with reference to the drawings, the same or equivalent components will be provided with the same reference numbers, and description thereof will not be repeated.

Hereinafter, a mobile terminal of the present disclosure will be explained in more detail with reference to the attached drawings. The suffixes "module" and "unit or portion" for components used in the following description merely provided only for facilitation of preparing this specification, and thus they are not granted a specific meaning or function. For the sake of brief description with reference to the drawings, the same or equivalent components will be provided with the same reference numbers, and description thereof will not be repeated. Singular expressions include plural expressions which do not have any obviously different meaning in view of a context.

The mobile terminal according to the present invention may include a portable phone, a smart phone, a laptop computer, a digital broadcasting terminal, Personal Digital Assistants (PDA), Portable Multimedia Player (PMP), a navigation system, etc. However, it will be obvious to those skilled in the art that the present invention may be also applicable to a fixed terminal such as a digital TV and a desktop computer.

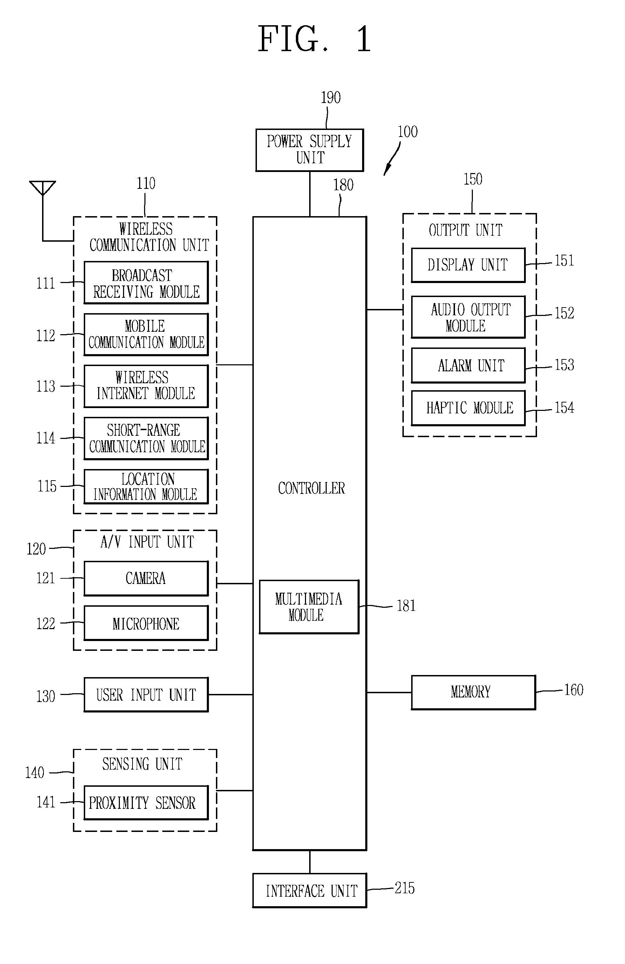

The mobile terminal 100 may comprise components, such as a wireless communication unit 110, an Audio/Video (A/V) input unit 120, a user input unit 130, a sensing unit 140, an output module 150, a memory 160, an interface unit 170, a controller 180, a power supply unit 190, and the like. FIG. 1 shows the mobile terminal 100 having various components, but it is understood that implementing all of the illustrated components is not a requirement. Greater or fewer components may alternatively be implemented.

Hereinafter, each component is described in sequence.

The wireless communication unit 110 may typically include one or more components which permit wireless communications between the mobile terminal 100 and a wireless communication system or between the mobile terminal 100 and a network within which the mobile terminal 100 is located. For example, the wireless communication unit 110 may include a broadcast receiving module 111, a mobile communication module 112, a wireless internet module 113, a short-range communication module 114, a position information module 115 and the like.

The broadcast receiving module 111 receives broadcast signals and/or broadcast associated information from an external broadcast management server (or other network entity) via a broadcast channel.

The broadcast channel may include a satellite channel and/or a terrestrial channel. The broadcast management server may be a server that generates and transmits a broadcast signal and/or broadcast associated information or a server that receives a previously generated broadcast signal and/or broadcast associated information and transmits the same to a terminal. The broadcast associated information may refer to information associated with a broadcast channel, a broadcast program or a broadcast service provider. The broadcast signal may include a TV broadcast signal, a radio broadcast signal, a data broadcast signal, and the like. Also, the broadcast signal may further include a broadcast signal combined with a TV or radio broadcast signal.

The broadcast associated information may also be provided via a mobile communication network and, in this case, the broadcast associated information may be received by the mobile communication module 112.

The broadcast signal may exist in various forms. For example, it may exist in the form of an electronic program guide (EPG) of digital multimedia broadcasting (DMB), electronic service guide (ESG) of digital video broadcast-handheld (DVB-H), and the like.

The broadcast receiving module 111 may be configured to receive signals broadcast by using various types of broadcast systems. In particular, the broadcast receiving module 111 may receive a digital broadcast by using a digital broadcast system such as multimedia broadcasting-terrestrial (DMB-T), digital multimedia broadcasting-satellite (DMB-S), digital video broadcast-handheld (DVB-H), the data broadcasting system known as media forward link only (MediaFLO^{®}), integrated services digital broadcast-terrestrial (ISDB-T), etc. The broadcast receiving module 111 may be configured to be suitable for every broadcast system that provides a broadcast signal as well as the above-mentioned digital broadcast systems.

Broadcasting signals and/or broadcasting associated information received through the broadcast receiving module 111 may be stored in the memory 160.

The mobile communication module 112 transmits/receives wireless signals to/from at least one of network entities (e.g., base station, an external terminal, a server, etc.) on a mobile communication network. Here, the wireless signals may include audio call signal, video call signal, or various formats of data according to transmission/reception of text/multimedia messages.

The wireless internet module 113 supports wireless Internet access for the mobile terminal. This module may be internally or externally coupled to the mobile terminal 100. Examples of such wireless Internet access may include Wireless LAN (WLAN) (Wi-Fi), Wireless Broadband (Wibro), World Interoperability for Microwave Access (Wimax), High Speed Downlink Packet Access (HSDPA), and the like.

The short-range communication module 114 denotes a module for short-range communications. Suitable technologies for implementing this module may include BLUETOOTH, Radio Frequency IDentification (RFID), Infrared Data Association (IrDA), Ultra-WideBand (UWB), ZigBee, and the like.

The position information module 115 denotes a module for sensing or calculating a position of a mobile terminal. An example of the position information module 115 may include a Global Position System (GPS) module.

Referring to FIG. 1, the A/V input unit 120 is configured to receive an audio or video signal. The A/V input unit 120 may include a camera 121, a microphone 122 or the like. The camera 121 processes image frames such as still images or moving images acquired by an image sensor in a video call mode or an image capturing mode. The processed image frames may be displayed on a display unit 151.

The image frames processed by the camera 121 may be stored in the memory 160 or transmitted to the outside via the wireless communication unit 110. Two or more cameras 121 may be provided according to the configuration of the mobile terminal.

The microphone 122 may receive sounds (audible data) via a microphone in a phone call mode, a recording mode, a voice recognition mode, and the like, and can process such sounds into audio data. The processed audio (voice) data may be converted for output into a format transmittable to a mobile communication base station via the mobile communication module 112 in case of the phone call mode. The microphone 122 may implement various types of noise canceling (or suppression) algorithms to cancel (or suppress) noise or interference generated while receiving and transmitting audio signals.

The user input unit 130 may generate input data for allowing a user to control various operations of the mobile communication terminal. The user input unit 130 may include a keypad, a dome switch, a touch pad (e.g., a touch sensitive member that detects changes in resistance, pressure, capacitance, etc. due to being contacted) a jog wheel, a jog switch, and the like.

The sensing unit 140 detects a current status (or state) of the mobile terminal 100 such as an opened or closed state of the mobile terminal 100, a location of the mobile terminal 100, the presence or absence of user contact with the mobile terminal 100 (e.g., touch inputs), the orientation of the mobile terminal 100, an acceleration or deceleration movement and direction of the mobile terminal 100, etc., and generates commands or signals for controlling the operation of the mobile terminal 100. For example, when the mobile terminal 100 is implemented as a slide type mobile phone, the sensing unit 140 may sense whether the slide phone is open or closed. In addition, the sensing unit 140 can detect whether or not the power supply unit 190 supplies power or whether or not the interface unit 170 is coupled with an external device. The sensing unit 140 may include a proximity sensor 141.

The output unit 150 is configured to provide outputs in a visual, audible, and/or tactile manner. The output unit 150 may include the display unit 151, an audio output module 152, an alarm unit 153, a haptic module 154, and the like.

The display unit 151 may display information processed in the mobile terminal 100. For example, when the mobile terminal 100 is in a phone call mode, the display unit 151 may display a User Interface (UI) or a Graphic User Interface (GUI) associated with a call. When the mobile terminal 100 is in a video call mode or image capturing mode, the display unit 151 may display a captured image and/or received image, or a UI or GUI.

The display unit 151 may include at least one of a Liquid Crystal Display (LCD), a Thin Film Transistor-LCD (TFT-LCD), an Organic Light Emitting Diode (OLED) display, a flexible display, a three-dimensional (3D) display, or the like.

Some of these displays may be configured to be transparent so that outside may be seen therethrough, which may be referred to as a transparent display. A representative example of the transparent display may include a Transparent Organic Light Emitting Diode (TOLED), and the like. The rear surface portion of the display unit 151 may also be implemented to be optically transparent. Under this configuration, a user can view an object positioned at a rear side of a body through a region occupied by the display unit 151 of the body.

The display unit 151 may be implemented in two or more in number according to a configured aspect of the mobile terminal 100. For instance, a plurality of displays may be arranged on one surface integrally or separately, or may be arranged on different surfaces.

Here, if the display unit 151 and a touch sensitive sensor (referred to as a touch sensor) have a layered structure therebetween, the structure may be referred to as a touch screen. The display unit 151 may be used as an input device rather than an output device. The touch sensor may be implemented as a touch film, a touch sheet, a touch pad, and the like.

The touch sensor may be configured to convert changes of a pressure applied to a specific part of the display unit 151, or capacitance occurring from a specific part of the display unit 151, into electric input signals. Also, the touch sensor may be configured to sense not only a touched position and a touched area, but also a touch pressure.

When touch inputs are sensed by the touch sensors, corresponding signals are transmitted to a touch controller (not shown). The touch controller processes the received signals, and then transmits corresponding data to the controller 180. Accordingly, the controller 180 may sense which region of the display unit 151 has been touched.

Referring to FIG. 1, a proximity sensor 141 may be arranged at an inner region of the mobile terminal blocked by the touch screen, or near the touch screen. The proximity sensor 141 indicates a sensor to sense presence or absence of an object approaching to a surface to be sensed, or an object disposed near a surface to be sensed, by using an electromagnetic field or infrared rays without a mechanical contact. The proximity sensor 141 has a longer lifespan and a more enhanced utility than a contact sensor.

The proximity sensor 141 may include a transmissive type photoelectric sensor, a direct reflective type photoelectric sensor, a mirror reflective type photoelectric sensor, a high-frequency oscillation proximity sensor, capacitance type proximity sensor, a magnetic type proximity sensor, an infrared rays proximity sensor, and so on. When the touch screen is implemented as capacitance type, proximity of a pointer to the touch screen is sensed by changes of an electromagnetic field. In this case, the touch screen (touch sensor) may be categorized into a proximity sensor.

Hereinafter, for the sake of brief explanation, a status that the pointer is positioned to be proximate onto the touch screen without contact will be referred to as 'proximity touch', whereas a status that the pointer substantially comes in contact with the touch screen will be referred to as 'contact touch'. For the position corresponding to the proximity touch of the pointer on the touch screen, such position corresponds to a position where the pointer faces perpendicular to the touch screen upon the proximity touch of the pointer.

The proximity sensor 141 senses proximity touch, and proximity touch patterns (e.g., distance, direction, speed, time, position, moving status, etc.). Information relating to the sensed proximity touch and the sensed proximity touch patterns may be output onto the touch screen.

The audio output module 152 may convert and output as sound audio data received from the wireless communication unit 110 or stored in the memory 160 in a call signal reception mode, a call mode, a record mode, a voice recognition mode, a broadcast reception mode, and the like. Also, the audio output module 152 may provide audible outputs related to a particular function performed by the mobile terminal 100 (e.g., a call signal reception sound, a message reception sound, etc.). The audio output module 152 may include a speaker, a buzzer, and so on.

The alarm unit 153 may provide outputs to inform about the occurrence of an event of the mobile terminal 100. Typical events may include call reception, message reception, key signal inputs, a touch input, etc. In addition to audio or video outputs, the alarm unit 153 may provide outputs in a different manner to inform about the occurrence of an event. The video signal or the audio signal may be output via the display unit 151 or the audio output module 152. Accordingly, the display unit 151 or the audio output module 152 may be classified as part of the alarm unit 153.

The haptic module 154 generates various tactile effects which a user can feel. A representative example of the tactile effects generated by the haptic module 154 includes vibration. Vibration generated by the haptic module 154 may have a controllable intensity, a controllable pattern, and so on. For instance, different vibration may be output in a synthesized manner or in a sequential manner.

The haptic module 154 may generate various tactile effects, including not only vibration, but also arrangement of pins vertically moving with respect to a skin being touched (contacted), air injection force or air suction force through an injection hole or a suction hole, touch by a skin surface, presence or absence of contact with an electrode, effects by stimulus such as an electrostatic force, reproduction of cold or hot feeling using a heat absorbing device or a heat emitting device, and the like.

The haptic module 154 may be configured to transmit tactile effects (signals) through a user's direct contact, or a user's muscular sense using a finger or a hand. The haptic module 154 may be implemented in two or more in number according to the configuration of the mobile terminal 100.

The memory 160 may store a program for the processing and control of the controller 180. Alternatively, the memory 160 may temporarily store input/output data (e.g., phonebook data, messages, still images, video and the like). Also, the memory 160 may store data relating to various patterns of vibrations and audio output upon the touch input on the touch screen.

The memory 160 may be implemented using any type of suitable storage medium including a flash memory type, a hard disk type, a multimedia card micro type, a memory card type (e.g., SD or DX memory), Random Access Memory (RAM), Static Random Access Memory (SRAM), Read-Only Memory (ROM), Electrically Erasable Programmable Read-only Memory (EEPROM), Programmable Read-only Memory (PROM), magnetic memory, magnetic disk, optical disk, and the like. Also, the mobile terminal 100 may operate a web storage which performs the storage function of the memory 160 on the Internet.

The interface unit 170 may generally be implemented to interface the mobile terminal with external devices. The interface unit 170 may allow a data reception from an external device, a power delivery to each component in the mobile terminal 100, or a data transmission from the mobile terminal 100 to an external device. The interface unit 170 may include, for example, wired/wireless headset ports, external charger ports, wired/wireless data ports, memory card ports, ports for coupling devices having an identification module, audio Input/Output (I/O) ports, video I/O ports, earphone ports, and the like.

The identification module may be configured as a chip for storing various information required to authenticate an authority to use the mobile terminal 100, which may include a User Identity Module (UIM), a Subscriber Identity Module (SIM), a Universal Subscriber Identity Module (USIM), and the like. Also, the device having the identification module (hereinafter, referred to as 'identification device') may be implemented in a type of smart card. Hence, the identification device can be coupled to the mobile terminal 100 via a port.

Also, the interface unit 170 may serve as a path for power to be supplied from an external cradle to the mobile terminal 100 when the mobile terminal 100 is connected to the external cradle or as a path for transferring various command signals inputted from the cradle by a user to the mobile terminal 100. Such various command signals or power inputted from the cradle may operate as signals for recognizing that the mobile terminal 100 has accurately been mounted to the cradle.

The controller 180 typically controls the overall operations of the mobile terminal 100. For example, the controller 180 performs the control and processing associated with telephony calls, data communications, video calls, and the like. The controller 180 may include a multimedia module 181 which provides multimedia playback. The multimedia module 181 may be configured as part of the controller 180 or as a separate component.

The controller 180 can perform a pattern recognition processing so as to recognize writing or drawing input on the touch screen as text or image.

The power supply unit 190 serves to supply power to each component by receiving external power or internal power under control of the controller 180.

Various embodiments described herein may be implemented in a computer-readable medium using, for example, software, hardware, or some combination thereof.

For a hardware implementation, the embodiments described herein may be implemented within one or more of Application Specific Integrated Circuits (ASICs), Digital Signal Processors (DSPs), Digital Signal Processing Devices (DSPDs), Programmable Logic Devices (PLDs), Field Programmable Gate Arrays (FPGAs), processors, controllers, micro-controllers, micro processors, other electronic units designed to perform the functions described herein, or a selective combination thereof. In some cases, such embodiments are implemented by the controller 180.

For software implementation, the embodiments such as procedures and functions may be implemented together with separate software modules each of which performs at least one of functions and operations. The software codes can be implemented with a software application written in any suitable programming language. Also, the software codes may be stored in the memory 160 and executed by the controller 180.

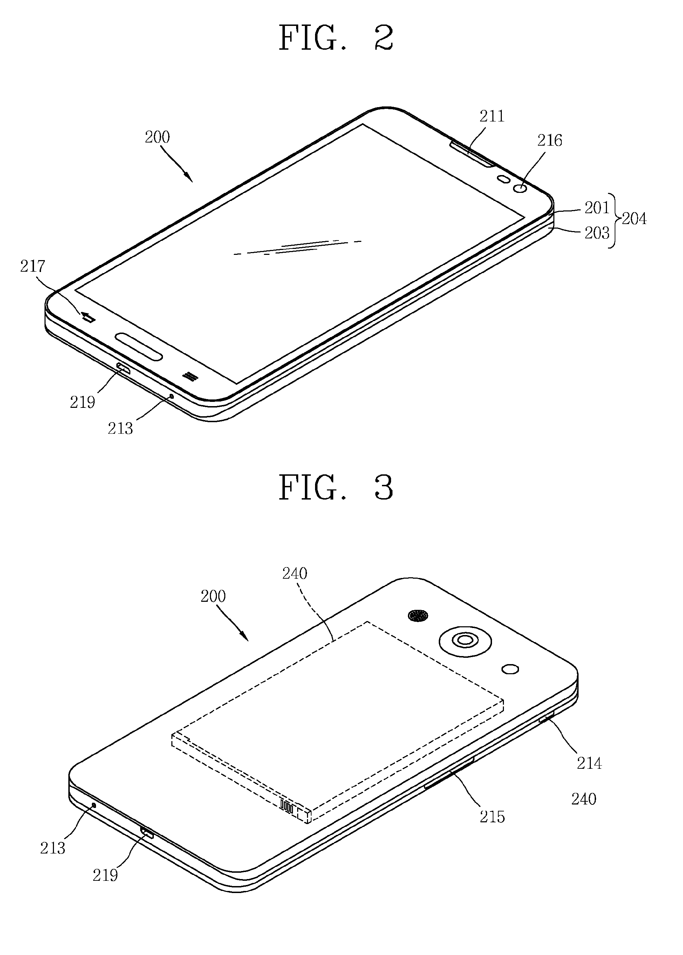

FIG. 2 is a front perspective view of a mobile terminal according to the present invention, and FIG. 3 is a rear perspective view of the mobile terminal of FIG. 2.

Referring to FIGS. 2 and 3, the mobile terminal 200 according to the present invention is provided with a bar type terminal body 204. However, the present invention is not limited to this, but may be applied to a slide type in which two or more bodies are coupled to each other so as to perform a relative motion, a folder type, a swing type, and the like. Further, the mobile terminal of the present invention may be applied to any portable electronic device having a camera and a flash, for instance, a portable phone, a smart phone, a notebook computer, a digital broadcasting terminal, Personal Digital Assistants (PDAs), Portable Multimedia Players (PMO), etc.

The mobile terminal 200 includes a terminal body 204 which forms the appearance thereof.

A case (casing, housing, cover, etc.) which forms the appearance of the terminal body 204 may include a front case 201, a rear case 202, and a battery cover 203 for covering the rear surface of the rear case 202.

A space formed by the front case 201 and the rear case 202 may accommodate various components therein. Such cases may be formed by injection-molded synthetic resin, or may be formed using a metallic material such as stainless steel (STS) or titanium (Ti).

On the front surface of the terminal body 204, may be disposed a display unit 210, a first audio output unit 211, a front camera 216, a side key 214, an interface unit 215, and a signal input unit 217.

The display unit 210 includes a liquid crystal display (LCD) module, organic light emitting diodes (OLED) module, e-paper, etc., each for visually displaying information. The display unit 210 may include a touch sensing means for inputting information in a touch manner. Hereinafter, the display unit 210 including the touch sensing means is called 'touch screen'. Once part on the touch screen 210 is touched, content corresponding to the touched position is input. The content input in a touch manner, may be characters, or numbers, or menu items which can be set in each mode. The touch sensing means may be transmissive so that the display can be viewed, and may include a structure for enhancing visibility of the touch screen at a bright place. Referring to FIG. 2, the touch screen 210 occupies most of the front surface of the front case 201.

The first audio output unit 211 may be implemented as a receiver for transmitting a call sound to a user's ear, or a loud speaker for outputting each type of alarm sound or a playback sound of multimedia.

The front camera 216 processes image frames such as still images or moving images, acquired by an image sensor in a video call mode or a capturing mode. The processed image frames may be displayed on the display unit 210.

The image frames processed by the front camera 216 may be stored in the memory 160, or may be transmitted to the outside through the wireless communication unit 110. The front camera 216 may be implemented in two or more according to a user's interface.

The user input unit 217 is manipulated to receive a command for controlling the operation of the mobile terminal 200, and may include a plurality of input keys. The input keys may be referred to as manipulation portions, and may include any type of ones that can be manipulated in a user's tactile manner.

For instance, the user input unit 217 may be implemented as a dome switch, or a touch screen, or a touch pad for inputting commands or information in a user's push or touch manner. Alternatively, the user input unit 217 may be implemented, for example, as a wheel for rotating a key, a jog, or a joystick. The user input unit 217 is configured to input various commands such as START, END and SCROLL.

A side key 214, an interface unit 215, an audio input unit 213, etc. are disposed on the side surface of the front case 201.

The side key 214 may be called 'manipulation unit', and may be configured to receive commands for controlling the operation of the mobile terminal 200. The side key 214 may include any type of ones that can be manipulated in a user's tactile manner. Content input by the side key 214 may be variously set. For instance, through the side key 214, may be input commands such as controlling the front and rear cameras 216 and 251, controlling the level of sound output from the audio output unit 211, and converting a current mode of the display unit 210 into a touch recognition mode.

The audio output unit 213 may be implemented as a microphone for receiving a user's voice, other sound, etc.

The interface unit 215 serves a path through which the mobile terminal 200 performs data exchange, etc. with an external device. For example, the interface unit 215 may be at least one of a connection terminal through which the mobile terminal 200 is connected to an ear phone by cable or radio, a port for local area communication, e.g., an infrared data association (IrDA) port, a Bluetooth portion, a wireless LAN port, and power supply terminals for supplying power to the mobile terminal 200. The interface unit 215 may be a card socket for accommodating an external card such as a subscriber identification module (SIM) card, a user identity module (UIM) card or a memory card for storing information.

A power supply unit 240 and the rear camera 221 are disposed on the rear surface of the body 204.

A flash 222 and a mirror (not shown) may be disposed close to the rear camera 221. When capturing an object by using the rear camera 221, the flash 222 provides light onto the object.

When the user captures an image of himself/herself by using the rear camera 221, the mirror can be used for the user to look at himself/herself therein.

The rear camera 221 may face a direction which is opposite to a direction faced by the front camera 216, and may have different pixels from those of the front camera 216.

For example, the front camera 216 may operate with relatively lower pixels (lower resolution). Thus, the front camera 216 may be useful when a user can capture his face and send it to another party during a video call or the like. On the other hand, the rear camera 221 may operate with a relatively higher pixels (higher resolution) such that it can be useful for a user to obtain higher quality pictures for later use. The front camera 216 and the rear camera 221 may be installed at the terminal body 204 so as to rotate or pop-up.

The power supply unit 240 is configured to supply power to the mobile terminal 200. The power supply unit 240 may be mounted in the terminal body 204, or may be detachably mounted to the terminal body 204.

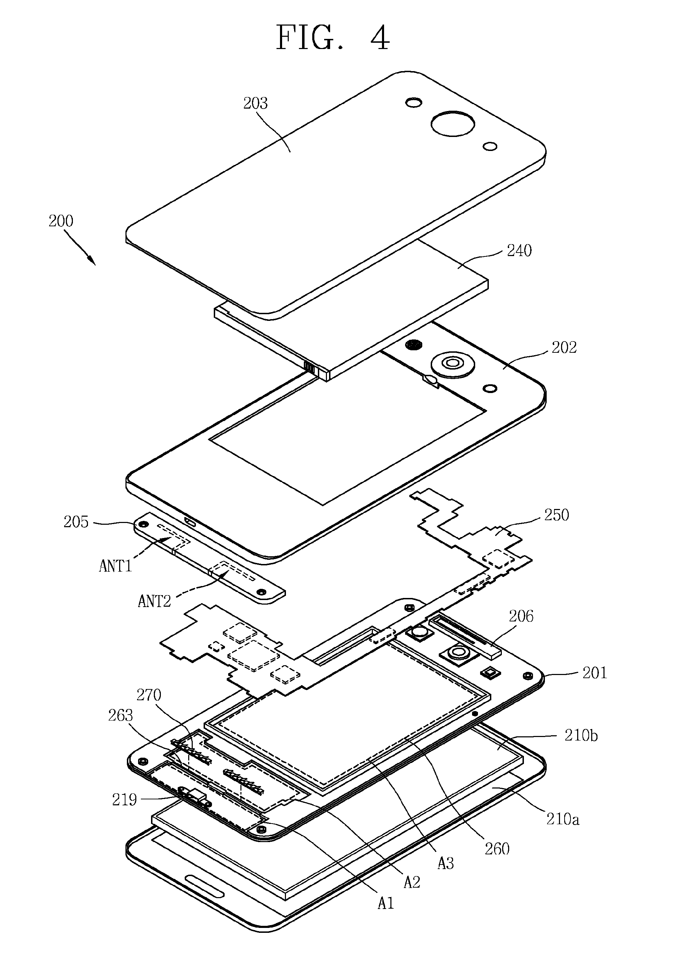

FIG. 4 is an exploded perspective view of FIG. 3.

Referring to FIG. 4, the mobile terminal includes a window 210a and a display module 210b which constitute the display unit 210. The window 210a may be coupled to one surface of the front case 201. The window 210a and the display module 210b may be integrally formed with each other.

A frame 260, configured to support electric devices, is formed between the front case 201 and the rear case 202. The frame 260, a structure for supporting inside of the mobile terminal, may be configured to support at least one of the display module 210b, the camera module 221, an antenna device, an antenna module having a plurality of antenna devices, the battery 240 and a printed circuit board 250.

The frame 260 may be formed so that one end thereof can be exposed to outside. Alternatively, the frame 260 may constitute part of a sliding module which connects a body and a display to each other in a slide-type mobile terminal rather than a bar-type mobile terminal.

Referring to FIG. 4, the printed circuit board 250 is disposed between the frame 260 and the rear case 202, and the display module 210b is coupled to one surface of the frame 260. The printed circuit board 250 and the battery 240 may be disposed on another surface of the frame 260. The battery case 203 may be coupled to the rear case 202 so as to cover the battery 240.

The window 210a is coupled to one surface of the front case 201. A touch sensing pattern 210c for sensing a touch input may be formed on one surface of the window 210a. The touch sensing pattern 210c is configured to sense a touch input, and is formed of a transmissive material. The touch sensing pattern 210c may be mounted to a front surface of the window 210a, and may be configured to convert a change of a voltage, etc. occurring from a specific part of the window 210a, into an electric input signal.

The display module 210b is mounted to a rear surface of the window 210a. In this embodiment, the display module 210b is implemented as a thin film transistor-liquid crystal display (TFT LCD). However, the present invention is not limited to this.

For instance, the display module 210b may be implemented as a liquid crystal display (LCD), an organic light-emitting diode (OLED), a flexible display, a 3-dimensional (3D) display, etc.

The printed circuit board 250 may be formed on one surface of the frame 260 as aforementioned. However, the printed circuit board 250 may be formed below the display module 210b. One or more electronic devices are mounted to a lower surface of the printed circuit board 250.

A battery accommodation portion, recessed to accommodate the battery 240 therein, is formed at the frame 260. A contact terminal, connected to the printed circuit board 250 so that the battery 240 can supply power to the body, 204 may be formed on one side surface of the battery accommodation portion.

The antenna device may be formed at an upper end or a lower end of the mobile terminal. The antenna device may be formed in plurality at the ends of the mobile terminal. In this case, the respective antenna devices may be configured to transmit and receive (transceive) radio signals in different frequency bands. Such antenna devices may comprise conductive pattern portions formed on one surface of a carrier. For instance, a carrier provided with a conductive member may be mounted to part 'A' in FIG. 4. The carrier may be coupled to the part 'A' of the case 201 using a coupling means such as screws. In this case, the screw may be coupled to a hole 262 of the case 201, by passing through a through hole of the carrier. A rib 263 of the frame 260 to be explained later may define a space where the carrier is mounted.

The frame 260 may be formed of a metallic material so as to have a sufficient strength even in a small thickness. The frame 260 formed of a metallic material may operate as a ground. That is, the printed circuit board 250 or the antenna device may be ground-connected to the frame 260, and the frame 260 may operate as a ground of the printed circuit board 250 or the antenna device. In this case, the frame 260 may extend a ground of the mobile terminal.

The printed circuit board 250 is electrically connected to the antenna device, and is configured to process radio signals (or radio electromagnetic waves) transmitted and received by the antenna device. For processing of radio signals, a plurality of transceiving circuits may be mounted to the printed circuit board 250.

The transceiving circuits may comprise one or more integrated circuits and related electric devices. As an example, the transceiving circuits may comprise a transmission integrated circuit, a reception integrated circuit, a switching circuit, an amplifier, etc.

As the plurality of transceiving circuits simultaneously feed conductive members formed as conductive pattern portions, a plurality of antenna devices may simultaneously operate. For instance, while one of the transceiving circuits performs signal transmission, another may perform signal reception. Alternatively, both of the transceiving circuits may perform signal transmission or signal reception.

A coaxial cable may be formed to connect the printed circuit board 250 with each antenna device. For instance, the coaxial cable may be connected to feeding devices for feeding antenna devices. The feeding devices may be formed on one surface of a flexible printed circuit board (FPCB) 242 for processing signals input from the user input unit 217. Another surface of the FPCB 242 may be coupled to a signal transmission unit for transmitting signals of the user input unit 217. In this case, a dome may be formed on another surface of the FPCB 242, and an actuator may be formed at the signal transmission unit.

An antenna device (ANT1) and an antenna device (ANT2) may be formed at one side and another side of the carrier, respectively. The respective antenna devices (ANT1, ANT2) are configured to transmit and receive signals of different frequency bands.

For instance, the first antenna device (ANT 1) may be configured to transmit and receive DCN 1x type or PCS 1x type signals. On the other hand, the second antenna device (ANT 2) may be configured to transmit and receive DCN EVDO (Evolution-Data Optimized or Evolution-Data Only) type signals.

If the first antenna device (ANT 1) is configured to transmit and receive LTE B4 type signals, the second antenna device (ANT 2) may be configured to transmit and receive LTE B13 type signals.

If the first antenna device (ANT 1) is configured to transmit and receive signals corresponding to voice service of the mobile terminal, the second antenna device (ANT 2) may be configured to transmit and receive signals corresponding to LTE service of the mobile terminal.

The flexible printed circuit board (FPCB) 242 is connected to a lower region of the carrier. One end of the FPCB 242 may be connected to the printed circuit board 250 having a controller. The FPCB 242 may be connected to the user input unit 217 of the mobile terminal. In this case, the FPCB 242 is formed so that a signal generated from the user input unit 217 can be transmitted to the controller of the printed circuit board 250. For instance, the FPCB 242 may be formed below the user input unit 217 so as to be connected to the user input unit 217, and so as to contact the signal transmission unit disposed between the user input unit 217 and the FPCB 242.

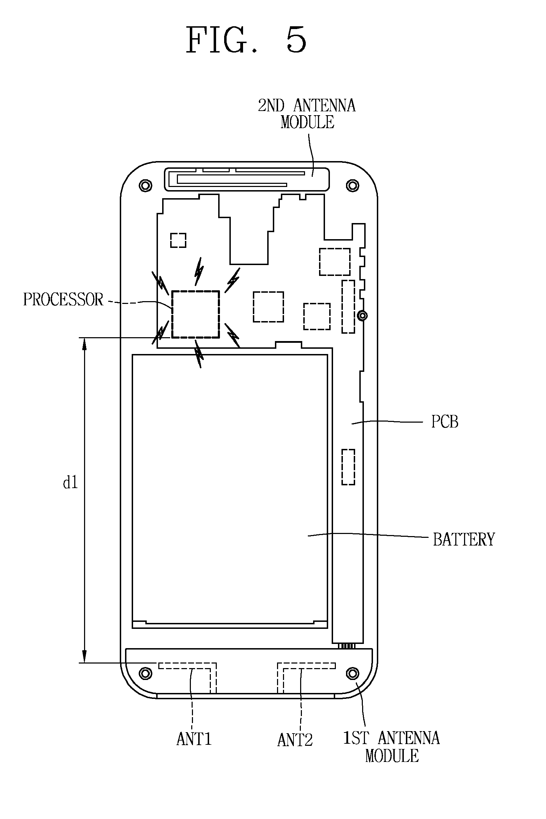

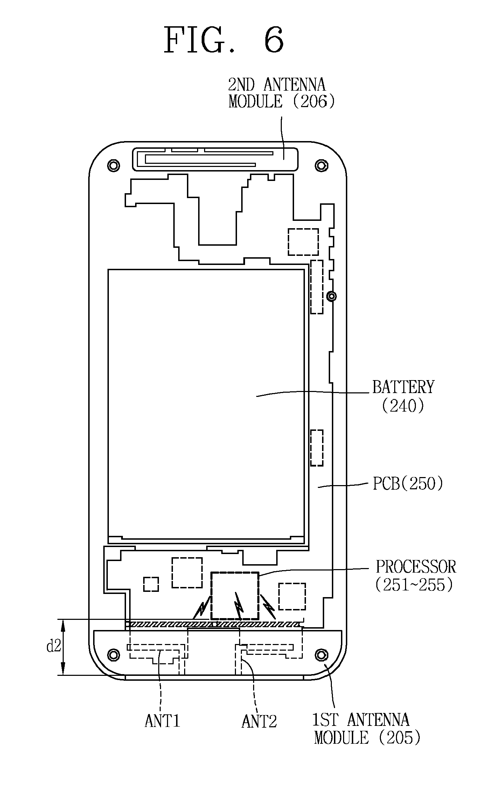

FIG. 5 is a conceptual diagram of a mobile terminal according to a comparative embodiment, which illustrates a state where a rear case has been removed from a terminal body. FIG. 6 is a conceptual diagram of a mobile terminal according to an embodiment of the present invention, which illustrates a state where a rear case has been removed from a terminal body.

Referring to FIGS. 5 and 6, a processor is mounted to one surface of the printed circuit board. Such processor may be a micro processor for communication or non-communication, which operates at a high speed. The micro processor may be implemented as a communication chip including a call processor, a modem chip, an RF transceiver chip and an RF receiver chip, and/or a power chip including a power amplifier (PA) chip and a power management IC (PMIC) chip. Alternatively, the micro processor may be an application processor (AP) configured to drive an OS or applications and to control various types of system devices or interfaces in the mobile terminal. Still alternatively, the micro processor may be an image signal processor (ISP) configured to convert an image signal into an electric signal, a video signal.

Such processor may cause electromagnetic interference (EMI) or radio frequency interference (RFI) because it is driven at a high speed. Especially, in a case where signal interference occurs from an antenna module, efficiency or electromagnetic characteristics of an antenna device may be changed.

Accordingly, as shown in FIG. 5, the antenna module and the processor may be spaced from each other by a distance more than a prescribed value, thereby minimizing interference therebetween.

If the battery is disposed at a central region of the terminal body as shown in FIG. 6, the processor and the antenna module are close to each other. The reason why the battery is disposed at a central region of the terminal body is in order to obtain higher charging efficiency when the mobile terminal is wirelessly charged. More specifically, when the battery is arranged at a position where a wireless power transmission coil of a wireless charger overlaps a wireless power reception coil of the mobile terminal with facing each other, wireless charging efficiency is high. However, if the battery is arranged at one side of the terminal body, coils cannot be effectively arranged. Accordingly, the battery is arranged at a central region of the terminal body, so that the wireless charging reception coil can be designed more effectively.

Further, the weight of the terminal body is mainly determined by the weight of the battery. If the battery is arranged at one-sided position, the center of gravity of the terminal body cannot be at a desired position. Accordingly, for an effective design of the center of gravity, the battery may be arranged at a central region of the terminal body.

In order to satisfy such design conditions, the battery of the mobile terminal according to the present invention may be arranged at a central region of the terminal body.

In this case, the printed circuit board may be formed to cover the battery. And the processor may be mounted to the printed circuit board positioned at an upper region or a lower region of the battery. The processor, formed near the antenna module as shown in FIG. 6, operates at a high speed, which may badly influence on the operation of an antenna device.

Referring to FIGS. 4 and 6 back, antenna modules may be mounted to an upper part and a lower part of the terminal body, respectively. A first antenna module 205 mounted at a lower part of the terminal body is a main antenna, which may be configured to provide voice service or LTE service of the mobile terminal. A second antenna module 206 mounted at an upper part of the terminal body may be configured to provide mobile communication service not provided from the first antenna module 205, e.g., GPS, Bluetooth, WIFI, etc. That is, communication service, which requires wireless signals of high efficiency or high quality, may be formed at an antenna of the first antenna module 205.

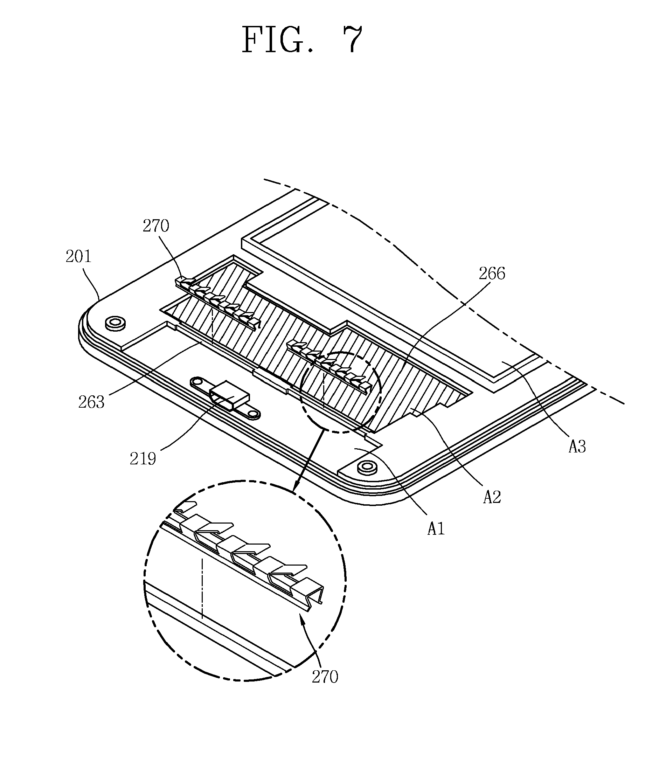

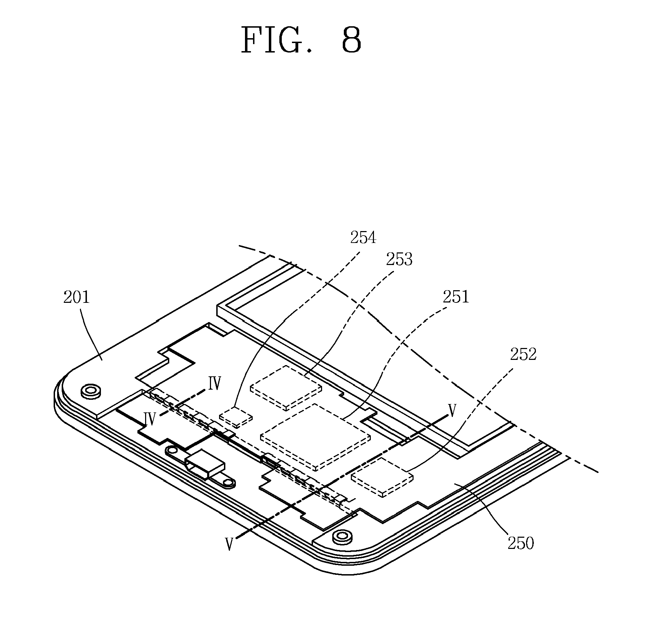

FIG. 7 is a perspective view illustrating a state where a printed circuit board and an antenna module have been removed from the terminal body of FIG. 6. FIG. 8 is a perspective view illustrating a state where the printed circuit board and the antenna module have been coupled to the terminal body of FIG. 7.

Referring to FIGS. 4 and 7, the frame 260, configured to support inside of the mobile terminal, may be coupled to the case. The window 210a may be coupled to the case. The case may be the front case 201.

The display module 210b may be coupled to a front surface of the frame 260, and may be supported by the frame 260. As shown in FIG. 8, a rear surface of the frame 260 may be supported by the frame 260, in a state where the battery 240, the printed circuit board 250, the first antenna module 205, the second antenna module 206, etc. have been mounted thereto.

The rear surface of the frame 260 may be divided into a region (A3) for mounting the battery 240, a region (A2) for mounting the printed circuit board 250, and a region (A1) for mounting the antenna module. A partition wall 263 may be formed so that the region (A1) for mounting the antenna module can be partitioned from the region (A2) for mounting the printed circuit board 250.

In case of coupling the printed circuit board 250 where processors 251, 252, 253, 254 and 255 have been mounted to the frame 260, an antenna device may be electromagnetically interfered by the operation of the processors 251, 252, 253, 254 and 255. In order to prevent such problem, a shielding member 270 is coupled to the partition wall 263. The shielding member 270 may be detachably coupled to the partition wall 263.

A shielding sheet 266 may be formed at a region where the printed circuit board 250 is to be mounted. That is, the shielding sheet 266 may be disposed between the printed circuit board 250 and the terminal body (more specifically, the frame 260), thereby reducing electromagnetic interference of the antenna device due to the operation of the processors. Further, the shielding sheet 266 may reduce electromagnetic interference of the processors due to the operation of the antenna device.

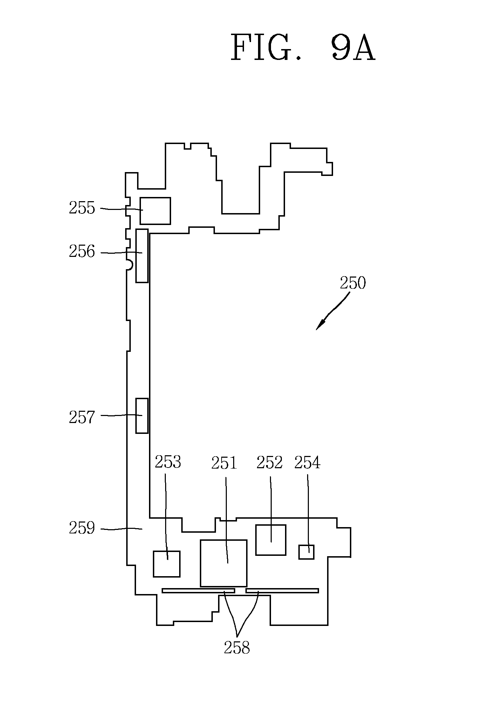

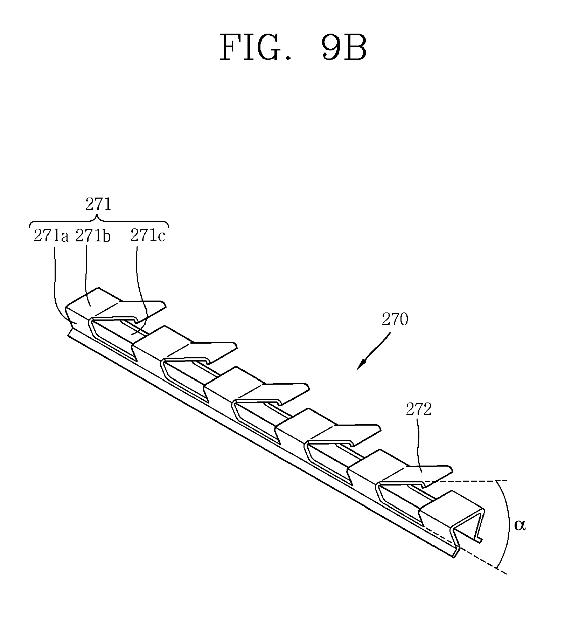

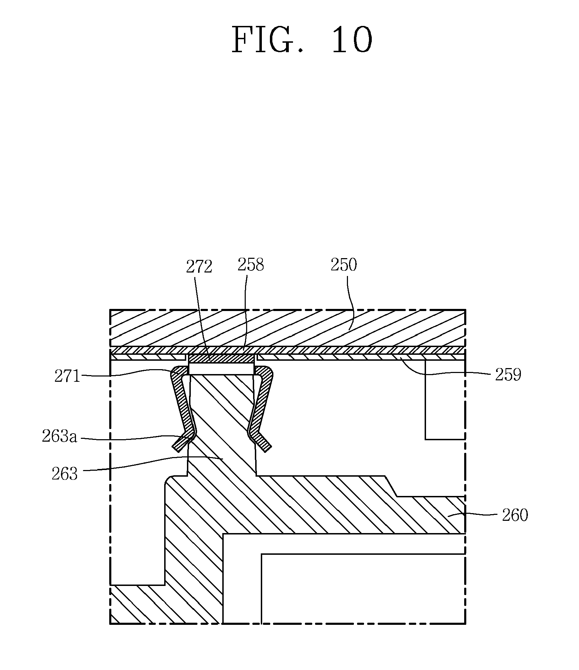

FIGS. 9A and 9B are conceptual diagrams illustrating the printed circuit board 250 and the shielding member 270 according to an embodiment of the present invention, respectively. FIG. 10 is a sectional view taken along line 'IV-IV' in FIG. 8.

Generally, the printed circuit board of the mobile terminal includes a mounted electronic circuit. The mounted electronic circuit is sensitive to electromagnetic interference (EMI) and radio frequency interference (RFI). Especially, the radio frequency interference (RFI) is generated from an interference source inside the mobile terminal, or an external interference source. In order to prevent such interference and protect electric devices, a shielding structure is required. As such shielding structures, a shielding member according to an embodiment of the present invention may be considered. The shielding member may be formed of stainless or titanium requiring no plating, and may be formed by molding in each step using a pressing method.

The printed circuit board includes a conductive layer, and a solder resist layer 259 formed on the conductive layer. The solder resist layer 259 is recessed from one surface of the printed circuit board so that the conductive layer formed therebelow can be exposed to outside. Protrusions 272 of the shielding member 270, which will be explained later, come in electrical-contact with a solder resist open (hereinafter will be referred to as 'conductive pattern portion').

The plurality of processors 251, 252, 253, 254 and 255 are mounted to the printed circuit board 250. Referring to FIGS. 4, 6 and 9A, the AP 251 and the CP 253 may be mounted on the printed circuit board 250 disposed between the battery 240 and the first antenna module. In this case, PMIC chips 252 and 254 may be connected to the AP 251 and the CP 253, respectively so as to manage power supplied to the AP 251 and the CP 253.

The ISP 255 may be mounted on the printed circuit board 250 disposed between the battery 240 and the second antenna module.

Reinforcing members 256 and 257, configured to reinforce intensity of the printed circuit board 250, may be formed at the printed circuit board 250. The reinforcing members 256 and 257 may be formed at part of the printed circuit board 250 having a relatively smaller thickness, thereby enhancing the entire intensity of the printed circuit board 250.

Referring to FIGS. 9B and 10, the shielding member 270 may include a base portion 271 and protrusions 272. The base portion 271 may be coupled to the partition wall 263 in a covering manner, thereby forming a shielding wall between the antenna module and the processor.

For resistance to a bending characteristic, the base portion 271 may have a section bent so that its upper region is narrow but its lower region is wide, or so that its upper region is wide but its lower region is narrow. As shown in FIG. 10, the base portion 271 may include a first member 271 a formed to contact an upper surface of the partition wall 263, and a second member 271 b or a third member 271 c formed to be inserted into groove portions 263a formed on two side surfaces of the partition wall 263. The second member 271 b or the third member 271 c, coupled to two side surfaces of the partition wall 263, may be formed to be elastically-transformable with respect to the first member 271 a.

The protrusion 272 may be formed in one or more in number. The protrusions 272 are formed on an upper surface of the base portion 271, so as to contact the conductive pattern portions 258 of the printed circuit board 250. The protrusions 272 are bent from an upper surface of the base portion 271, toward an upper side. The protrusions 272 are formed to have a prescribed inclination angle (α) from a bending line. The protrusions 272 may be formed to have an elastic force more than a prescribed value, thereby attenuating an impact applied to an electric device and maintaining an excellent contact with the printed circuit board. That is, the protrusions 272 may be formed of an elastic member such that its inclination angle is variable according to a pressurized degree.

Generally, a right side surface or a left side surface of the conductive pattern portion 258 of the printed circuit board 250 has a width of about 1.2 mm. Accordingly, a central region of the conductive pattern portion 258 should be disposed within a range spaced from the side surfaces by 0.3 mm ∼ 0.45 mm. The protrusions 272 should be arranged to contact the central region of the conductive pattern portions 258.

Especially, if the conductive pattern portions 258 of the printed circuit board 250 are coupled to the protrusions 272 at the central region thereof, electromagnetic interference (EMI) and radio frequency interference (RFI) of the mobile terminal are reduced. Further, inferiority of the mobile terminal due to an assembly tolerance, which occurs when assembling the protrusions 272 and the conductive pattern portions 258, can be prevented. Besides, a ground of the printed circuit board 250 can be extended, and electromagnetic waves can be effectively shielded. That is, in order to enhance a shielding function by the shielding member, eccentricity of the protrusions 272 should be prevented so that the protrusions 272 and the conductive pattern portions 258 can be coupled to each other at the central region of the conductive pattern portions 258, not at the edge regions. In order to prevent eccentricity of the protrusions, the width of the conductive pattern portion (SR Open) can be increased. However, in this case, the size of the printed circuit board should be increased. This may cause a limitation in reducing the size of the mobile terminal.

One end of the protrusions 272 may be formed sharply so as to well-contact the conductive pattern portions 258, or formed to be round by having the edge removed.

The shielding sheet 266 and the shielding member 270 are formed to cover at least part of various types of electric devices of the printed circuit board 250, when the frame 260 and the printed circuit board 250 are coupled to each other. Under such configuration, a specific absorption rate (SAR) of the mobile terminal can be enhanced.

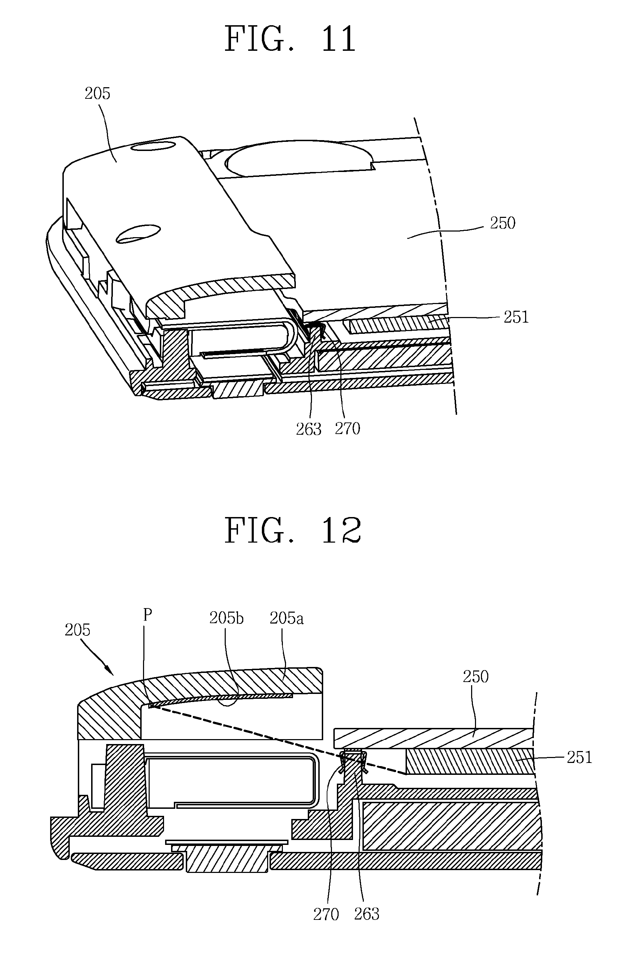

FIGS. 11 and 12 are sectional views taken along line 'V-V' in FIG. 8, respectively.

Hereinafter, the first module 205, formed at a lower region of the body of the mobile terminal and including a main antenna, will be explained as an antenna module.

The antenna module 205 may be formed to include one or more antenna devices (ANT1, ANT2). That is, two or more radiators of antenna devices may be formed at one antenna module 205.

For instance, if the single antenna module 205 includes two antenna devices, radiators of the two antenna devices may be implemented in the form of conductive patterns 205b printed on an outer surface or an inner surface of a carrier 205a. If the radiator of the first antenna device is formed at the left side of the carrier 205a, the radiator of the second antenna device may be formed at the right side of the carrier 205a. In such antenna devices, a point where a maximum current flows, i.e., wireless signals are radiated to the maximum, may be formed at one end of each radiator.

Referring to FIGS. 11 and 12, the shielding member 270 according to the present invention may be positioned on a virtual line which connects a point (P) of each antenna device where a maximum current flows, to the processors. Under such configuration, radiation of wireless signals, occurring from a maximum radiation point of the antenna devices toward the processors, can be prevented.

Owing to the shielding member 270, not only electromagnetic interference of an antenna device due to the operation of the processors can be reduced, but also electromagnetic interference of the processors due to the operation of the antenna device can be reduced.

In a case where the antenna device is formed in plurality, the shielding member 270 may be also formed in plural, so as to effectively shield signals radiated from the respective antenna devices. Each of the shielding members 270 may shield a wireless signal radiated toward one processor, from a maximum radiation point of the antenna devices.

One of the shielding members 270 may shield a wireless signal radiated toward the AP 251 from one antenna, or a wireless signal radiated toward one antenna from the AP 251. Another shielding member 270 may shield a wireless signal radiated toward the CP 253 from another antenna, or a wireless signal toward another antenna from the CP 253.

The mobile terminal according to at least one of embodiments of the present invention can have the following advantages.

Firstly, electromagnetic interference of the antenna device due to the operation of the processors can be reduced. Further, electromagnetic interference of the processors due to the operation of the antenna device can be reduced.

The foregoing embodiments and advantages are merely exemplary and are not to be considered as limiting the present disclosure. The present teachings can be readily applied to other types of apparatuses. This description is intended to be illustrative, and not to limit the scope of the claims. Many alternatives, modifications, and variations will be apparent to those skilled in the art. The features, structures, methods, and other characteristics of the exemplary embodiments described herein may be combined in various ways to obtain additional and/or alternative exemplary embodiments.

As the present features may be embodied in several forms without departing from the characteristics thereof, it should also be understood that the above-described embodiments are not limited by any of the details of the foregoing description, unless otherwise specified, but rather should be considered broadly within its scope as defined in the appended claims, and therefore all changes and modifications that fall within the metes and bounds of the claims, or equivalents of such metes and bounds are therefore intended to be embraced by the appended claims.

## Claims

1. A mobile terminal, comprising:
a case (201) having a window on one surface thereof;
a battery (240) and an antenna module (205, 206) mounted in the case, and spaced from each other;
a printed circuit board (250) having one or more processors, and disposed between the battery and the antenna module;
a frame (260) configured to support the printed circuit board;
a partition wall (263) formed at the frame such that a region for mounting the antenna module is partitioned from a region for mounting the printed circuit board; and
a shielding member (270) coupled to the partition wall, such that electromagnetic interference of an antenna device due to an operation of the processor is prevented.

2. The mobile terminal of claim 1, further comprising a shielding sheet (266) disposed between the printed circuit board and the frame.

3. The mobile terminal of any one of claims 1 to 2, wherein the printed circuit board comprises:
a solder resist layer (259) formed to cover one surface of the printed circuit board; and
conductive pattern portions (258) recessed from the solder resist layer, and exposed to outside in a preset pattern.

4. The mobile terminal of claim 3, wherein the shielding member comprises:
a base portion (271) coupled to the partition wall in a covering manner; and
protrusions (272) bent from the base portion, and formed to be upright with a prescribed inclination angle toward the printed circuit board.

5. The mobile terminal of claim 4, wherein the protrusions come in electrical-contact with the conductive pattern portions.

6. The mobile terminal of claim 5, wherein the protrusion is formed of an elastic member such that its upright angle is variable according to a pressurized degree.

7. The mobile terminal of claim 4, wherein groove portions are formed on two side surfaces of the partition wall, and
wherein part of the base portion is inserted into the groove portion.

8. The mobile terminal of any one of claims 1 to 7, wherein the antenna module comprises radiators formed to resonate at a prescribed frequency, respectively, and
wherein the radiators are formed as conductive patterns printed onto one surface of a carrier.

9. The mobile terminal of claim 8, wherein the radiators comprise one or more points where a maximum current flows when wireless signals are transmitted and received in different modes, and
wherein the shielding member is disposed on a virtual line which connects the points and the processor with each other.

10. The mobile terminal of claim 9, wherein the shielding member is formed in plurality in number, and each of the plurality of shielding members is coupled to the partition wall.

11. The mobile terminal of any one of claims 1 to 10, wherein the shielding member is detachably coupled to the partition wall.
